# EUROPÄISCHE PATENTSCHRIFT

(11) **EP 2 092 287 B1**
(45) Veröffentlichungstag und Bekanntmachung des Hinweises auf die Patenterteilung: **11.01.2017**
(21) Anmeldenummer: 07820338.7
(22) Anmeldetag: 19.09.2007
(51) Int. Cl.: G01L 9/00, H01L 21/56, G01L 19/14

(54) **VORRICHTUNG ZUR PASSIVIERUNG EINES BAUELEMENTS UND VERFAHREN ZUR HERSTELLUNG DER VORRICHTUNG**
APPARATUS FOR PASSIVATING A COMPONENT, AND METHOD FOR PRODUCING THE APPARATUS
DISPOSITIF DE PASSIVATION D'UN COMPOSANT ET PROCÉDÉ DE FABRICATION DU DISPOSITIF

(30) Priorität: 09.11.2006 DE 102006052811; 16.08.2007 DE 102007038515
(43) Veröffentlichungstag der Anmeldung: 26.08.2009
(73) Patentinhaber: Robert Bosch GmbH, 70442 Stuttgart (DE)
(72) Erfinder: MUELLER, Stefan, 88142 Wasserburg (DE); HAAG, Frieder, 72827 Wannweil (DE)
(86) Internationale Anmeldenummer: PCT/EP2007/059894
(87) Internationale Veröffentlichungsnummer: WO 2008/055736

(56) Entgegenhaltungen:
- EP-A- 1 211 721
- DE-A1- 19 929 026
- US-A1- 2003 214 021

## Beschreibung

Die Erfindung bezieht sich auf eine Sensoranordnung gemäß dem unabhängigen Anspruch. Aus der deutschen Offenlegungsschrift DE 199 29 026 A1 ist ein Verfahren bekannt, bei dem ein Halbleiterdruckaufnehmer auf einen Montageabschnitt eines Leitungsgitters aufgebracht wird, der Halbleiterdruckaufnehmer mit Kontaktabschnitten des Leitungsgitters elektrisch verbunden wird, das Leitungsgitter mit dem Halbleiterdruckaufnehmer in ein Spritzwerkzeug eingesetzt wird und anschließend der Halbleiterdruckaufnehmer in dem Spritzwerkzeug mit einem Gehäuse aus Spritzmasse umgeben wird, wobei während des Umspritzens ein Stempel im Spritzwerkzeug durch einen Spalt zu der von dem Halbleiterdruckaufnehmer abgewandten Seite des Montageabschnittes beabstandet angeordnet ist und hinsichtlich seiner Temperatur gesteuert ist. Nachteilig hierbei ist jedoch der relativ komplizierte Aufbau des Stempels. So muss der Stempel mit einer Heizvorrichtung oder aber einer Kühlvorrichtung verbunden werden. Zudem führen bereits geringe Toleranzabweichungen bei der Größe und der Form des Stempels zu einer Beschädigung des Chips entweder durch Druck des Stempels auf den Chip oder durch Eindringen von Spritzmasse in einen zu großen Spalt zwischen Stempel und Halbleiterdruckaufnehmer. Weitere Dokumente, die den Stand der Technik dokumentieren sind EP 1 211 721 A und US 2003 / 214 021 A1.

### Vorteile der Erfindung

Die erfindungsgemäße Vorrichtung zur Passivierung eines Bauelements und das Verfahren zur Herstellung der Vorrichtung gemäß den Merkmalen der nebengeordneten Ansprüche hat demgegenüber den Vorteil, dass Toleranzen im Spritzwerkzeug ausgeglichen werden können und zusätzlich ein Teilbereich des Substrats vor der Spritzmasse (Mold- Compond) geschützt werden kann. Unter einem Bauelement im Sinne der Erfindung kann auch eine Kombination aus einzelnen und miteinander verpackten Bauteilen verstanden werden. Beispielsweise können mehrere Chips und eine Drahtbondverbindung zwischen den Chips die einzelnen Bauteile eines Bauelements darstellen. Insbesondere bei der Massenfertigung von Gehäusen für Bauelemente können durch die wirkenden Kräfte Veränderungen des Spritzwerkzeuges entstehen. Sofern das Gehäuse durch zwei Spritzwerkzeughälften, die zusammen eine Kavität bilden, hergestellt wird, können zudem Verschiebungen der Spritzwerkzeughälften gegeneinander auftreten, was an ihren Auflageflächen zu Abdichtproblemen oder einer starken Materialbelastung führt. Erfindungsgemäß werden diese Probleme reduziert. Hierzu weist die erfindungsgemäße Vorrichtung einen Montageträger auf, der im folgenden auch als Diepad bezeichnet wird. Zumindest Teilbereiche des Diepads befinden sich in einer Ebene im wesentlichen parallel zur Haupterstreckungsebene des Substrates, wobei das Diepad das Substrat in dieser Ebene im wesentlichen vollständig umgibt. Hierdurch ist es erfindungsgemäß vorteilhaft möglich, dass die Spritzwerkzeughälften nicht direkt aufeinander schließen, sondern im wesentlichen vollständig auf dem Montageträger schließen. Der Fachmann versteht, dass bei einem Spritzverfahren die Spritzmasse mit einem hohen Druck in die Kavität des Spritzwerkzeuges eingeführt wird und dass die Spritzmasse, je nach verwendetem Material, sehr dünnflüssig sein kann. Der Fachmann versteht daher weiterhin, dass die Auflageflächen der Spritzwerkzeughälften, mit denen die Spritzwerkzeughälften bei der Produktion der erfindungsgemäßen Vorrichtung in Kontakt zueinander stehen, möglichst ohne freie Spalten zueinander schließen müssen. In Bereichen in denen die Auflageflächen der Spritzwerkzeughälften nicht fest miteinander schließen, kann Spritzmasse austreten und in Bereiche des zu fertigenden Gehäuses gelangen, die eigentlich frei von Spritzmasse verbleiben sollten. Es liegt dann eine sogenannte Überspritzung vor. Insbesondere ein Überspritzen von eigentlich freizulassenden Sensoren führt dabei zu einer Fehlproduktion, die mit Kosten verbunden ist. Durch eine geringe Verformbarkeit des Diepads ist es erfindungsgemäß jedoch möglich, geringe Toleranzen der Auflageflächen des Spritzwerkzeuges auszugleichen und zudem den Verschleiß der Spritzwerkzeuge zu reduzieren, da die harten Materialien der Spritzwerkzeughälften bei der Produktion eines Gehäuses nicht mehr direkt mit großem Druck aufeinander gepresst werden, sondern sich zwischen den Spritzwerkzeughälften ein Puffer in Form des Montageträgers befindet.

Besonders bevorzugt ist zudem, wenn zumindest Teilbereiche des Diepads gekröpft vorgesehen sind. Unter Kröpfen im Sinne der Erfindung soll dabei verstanden werden, wenn ein Gegenstand mittels einer Doppelbiegung hinsichtlich seiner lokalen Haupterstreckungsebene geändert wird. Vorzugsweise weist der Bereich zwischen den beiden Biegungen der Doppelbiegung einen Winkel von 45° zu den nicht gekröpften Teilen des Diepads auf. Es sind jedoch auch andere Winkel möglich.

Weiterhin bevorzugt ist, wenn die Passivierung des Bauelements mittels Umspritzung des Bauelements mittels einer Spritzmasse vorgesehen ist, wobei das Substrat lediglich in einem ersten Substratbereich von dem Gehäuse im wesentlichen vollständig umgeben ist. Hierdurch ist es erfindungsgemäß möglich, den durch das Substrat gebildeten Chip vor Umwelteinflüssen, wie Feuchtigkeit oder Schmutz zu schützen. Auf der anderen Seite kann der zweite Substratbereich, der nicht vom Gehäuse umschlossen ist, von einer Beeinflussung durch das Gehäuse geschützt werden. So kann eine thermische Ausdehnung des Gehäuses beispielsweise nicht direkt auf den zweiten Substratbereich wirken. Beispielsweise kann sich im zweiten Substratbereich ein aktiver Sensorbereich befinden, welcher somit besser vor Spannungen, die durch das Gehäuse induziert werden, geschützt ist. Es ist somit erfindungsgemäß bevorzugt, wenn es sich bei dem Bauelement mit Gehäuse um eine Sensoranordnung handelt. Bei dem Substrat kann es sich beispielsweise um ein Halbleitersubstrat, bevorzugt ein Silizium- Substrat, insbesondere ein SOI-Substrat handeln. Die Umspritzung des Bauelements kann beispielsweise durch Mold-Compound in einem entsprechenden Transfermoldingverfahren erfolgen. Es sind jedoch auch andere Verfahren zur Herstellung des Gehäuses denkbar und auch andere Substrate als das oben aufgeführte Substrat.

Besonders bevorzugt befindet sich der gekröpfte Bereich des Diepads in der Mittelebene des Substrates. Unter der Mittelebene des Substrates soll hierbei eine Ebene verstanden werden, die sich im wesentlichen parallel zur Haupterstreckungsebene befindet und in einer Höhe liegt, die im wesentlichen der Mitte des Substrates entspricht. Hierdurch ist es erfindungsgemäß möglich, die Höhe des Substrates auszugleichen, so dass das Werkzeug auf beiden Seiten im wesentlichen gleichartig ausgeführt werden kann. Erfindungsgemäß besonders bevorzugt weist dabei das Diepad eine Aussparung auf, wobei der zweite Substratbereich im Bereich der Aussparung vorgesehen ist.

### Zeichnungen

Ausführungsbeispiele der Erfindung sind in den Zeichnungen dargestellt und in der nachfolgenden Beschreibung näher erläutert.
Figur 1 zeigt schematisch eine Schnittdarstellung einer erfindungsgemäßen Vorrichtung.
Figur 2 stellt schematisch die Vorrichtung in einer Draufsicht dar.
Figur 3 zeigt schematisch einen Schnitt durch die Kavität eines Spritzwerkzeuges.

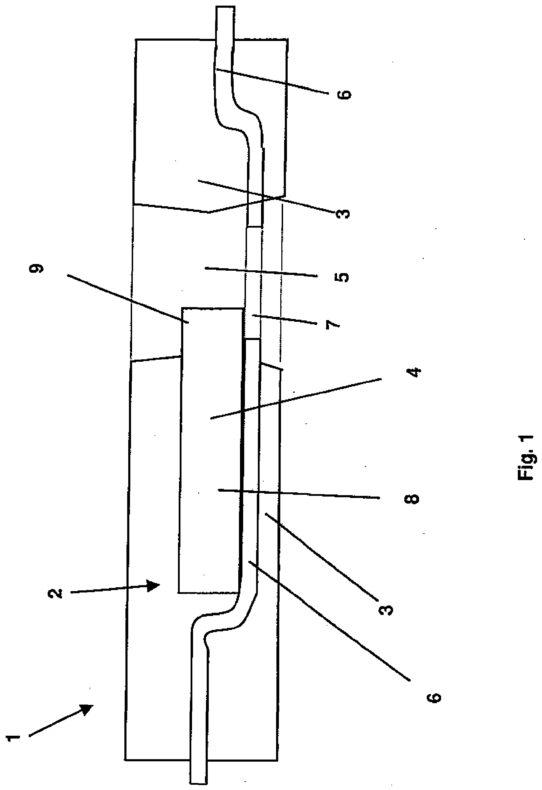

In Figur 1 ist schematisch eine Schnittdarstellung durch eine erfindungsgemäße Vorrichtung 1 mit einem Gehäuse 3 dargestellt. Hierbei umschließt das Gehäuse 3 teilweise ein Substrat 4. Das Substrat 4 kann in zwei Bereiche eingeteilt werden - einen ersten Substratbereich 8 und einen zweiten Substratbereich 9. Durch das Gehäuse 3 wird der erste Substratbereich 8 vor Beschädigungen oder Schmutz geschützt. Der zweite Substratbereich 9 ist in einer Öffnung 5 des Gehäuses 3 dargestellt und kann zum Beispiel einen aktiven Sensorbereich aufweisen. Ein Montageträger 6, der im Folgenden auch als Diepad 6 bezeichnet wird, befindet sich unter dem ersten Substratbereich 8, wobei das Diepad 6 eine Aussparung 7 aufweist. Diese Aussparung 7 befindet sich im Bereich der Öffnung 5. Ein Teilbereich des Diepads 6 ist durch Kröpfen in die Mittelebene des Substrates 4 parallel zu dessen Haupterstreckungsrichtung gezogen. Erfindungsgemäß ist es hierdurch möglich, die Dicke des Substrates 4 auszugleichen. Im Ausführungsbeispiel umfasst das Bauelement 2 das Substrat 4 und das Diepad 6. Die Vorrichtung 1 umfasst im Ausführungsbeispiel das Bauelement 2 mit dem Gehäuse 3.

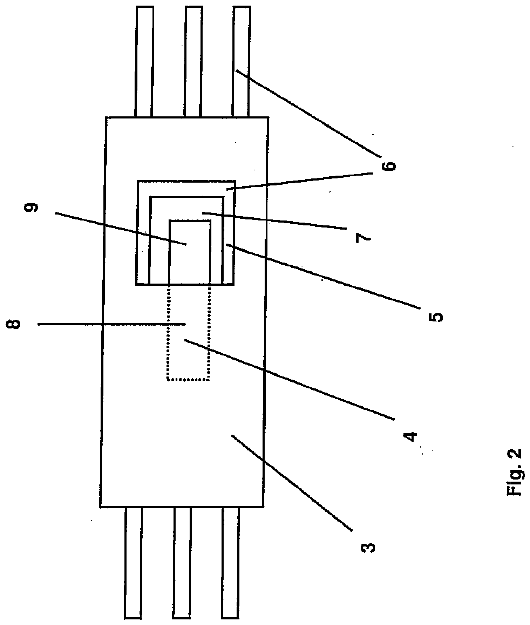

In der Figur 2 ist eine schematische Draufsicht auf die erfindungsgemäße Vorrichtung 1 dargestellt. In der Öffnung 5 des Gehäuses 3 ist der zweite Substratbereich 9 des Substrates 4 vorgesehen. Der erste Substratbereich 8 ist von dem Gehäuse 3 umschlossen und wird daher in gestrichelten Linien eingezeichnet. Das Diepad 6 ist ebenfalls in der Öffnung 5 dargestellt. Der zweite Substratbereich 9 befindet sich in der Öffnung 5 und in der Aussparung 7 des Diepads 6 und kann so weder durch das Gehäuse 3 noch durch das Diepad 6 beeinflusst werden.

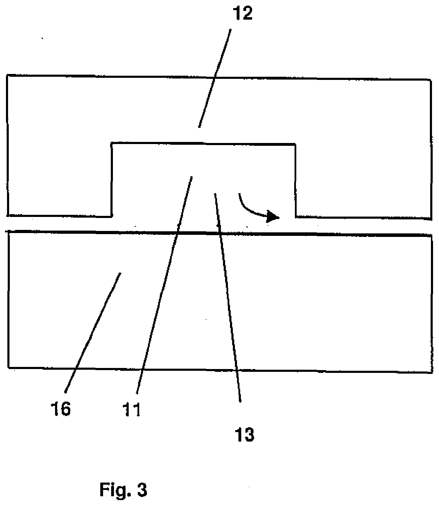

In Figur 3 ist schematisch ein Schnitt durch eine Kavität 11 eines Spritzwerkzeuges dargestellt. Eine erste Spritzwerkzeughälften 12 soll auf dem Bauelement 2 (nicht dargestellt in der Figur 3) oder auf einer zweiten Spritzwerkzeughälfte 16 liegen. Durch Abnutzungen der Spritzwerkzeughälften 12, 16 oder durch nicht exaktes Schließen der Spritzwerkzeughälften 12, 16 kann ein Spalt entstehen, durch den sich Spritzmasse 13 beispielsweise in Richtung des Pfeils durchdrücken kann. Hierdurch kann es zu einer Überspritzung von eigentlich frei zubleibenden Bereichen kommen, die unter Umständen die Funktion des im Gehäuse 3 befindlichen Bauelements 2 stören. Bei der Herstellung des Gehäuses 3 (mit Bauelement 2) befindet sich zwischen zwei Spritzwerkzeughälften 12, 16 das Diepad 6. Geringe Toleranzen beim Schließen des Spritzwerkzeuges können so durch eine Deformation des Diepads 6 ausgeglichen werden. Damit kann verhindert werden, dass die Spritzmasse 13 in Bereiche gedrückt wird, die eigentlich frei bleiben sollen.

## Patentansprüche

1. Sensoranordnung (1), bei der ein Bauelement (2) in einem Gehäuse (3) passiviert ist, wobei das Bauelement (2) ein Substrat (4) und einen Montageträger (6) umfasst, wobei das Gehäuse (3) das Substrat (4) in einem ersten Substratbereich (8) im Wesentlichen vollständig umgibt, wobei das Gehäuse (3) in einem zweiten Substratbereich (9) im Wesentlichen mittels einer Öffnung (5) geöffnet vorgesehen ist,
wobei in einer Ebene parallel zur Haupterstreckungsebene des Substrates (4) ein Montageträger (Diepad) (6) das Substrat (4) im Wesentlichen vollständig umgibt,
wobei
• der zweite Substratbereich (9) einen Sensorbereich aufweist, und
• der Montageträger (6) gekröpft vorgesehen ist und ein Abschnitt der Montageträger (6) durch das Kröpfen in einer Mittelebene des Substrates (4) parallel zur Haupterstreckungsebene gezogen vorgesehen ist, **dadurch gekennzeichnet, dass**
• der Montageträger (6) eine Aussparung (7) im Bereich der Öffnung (5) aufweist, und
• der zweite Substratbereich (9) im Bereich der Aussparung (7) des Montageträgers (6) vorgesehen ist.

2. Sensoranordnung
(1) nach einem der vorhergehenden Ansprüche, **dadurch gekennzeichnet, dass** die Passivierung des Bauelements (2) durch Umspritzung des Bauelements (2) mittels einer Spritzmasse (13) vorgesehen ist, wobei das Substrat (4) lediglich im ersten Substratbereich (8) von dem Gehäuse (3) im Wesentlichen vollständig umgeben ist.

## Claims

1. Sensor arrangement (1), in which a component (2) in a housing (3) is passivated, wherein the component (2) comprises a substrate (4) and a mounting support (6), wherein the housing (3) surrounds the substrate (4) substantially completely in a first substrate region (8), wherein the housing (3) is provided such that it is substantially opened by means of an opening (5) in a second substrate region (9),
wherein a mounting support (die pad) (6) surrounds the substrate (4) substantially completely in a plane parallel to the main plane of extent of the substrate (4),
wherein
• the second substrate region (9) has a sensor region, and
• the mounting support (6) is provided offset and, as a result of the offsetting, a portion of the mounting support (6) is provided as drawn parallel to the main plane of extent in a central plane of the substrate (4),
**characterized in that**
• the mounting support (6) has a recess (7) in the region of the opening (5), and
• the second substrate region (9) is provided in the region of the recess (7) of the mounting support (6).

2. Sensor arrangement (1) according to one of the preceding claims, **characterized in that** the passivation of the component (2) is provided by encapsulating the component (2) by means of an injection-moulding compound (13), wherein the substrate (4) is only surrounded substantially completely by the housing (3) in the first substrate region (8).

## Revendications

1. Arrangement de détection (1), avec lequel un composant (2) est rendu passif dans un boîtier (3), le composant (2) comprenant un substrat (4) et un support de montage (6), le boîtier (3) entourant sensiblement entièrement le substrat (4) dans une première zone de substrat (8), le boîtier (3) étant réalisé ouvert dans une deuxième zone de substrat (9) sensiblement au moyen d'une ouverture (5),
un support de montage (6) (pastille à puce) entourant sensiblement entièrement le substrat (4) dans un plan parallèle au plan de projection principal du substrat (4),
* la deuxième zone de substrat (9) possédant une zone de capteur et
* le support de montage (6) étant réalisé coudé et une portion du support de montage (6), par le coudage dans un plan central du substrat (4), étant réalisée étirée parallèlement au plan de projection principal, **caractérisé en ce que**
* le support de montage (6) possède un évidement (7) dans la zone de l'ouverture (5), et
* la deuxième zone de substrat (9) se trouve dans la zone de l'évidement (7) du support de montage (6).

2. Arrangement de détection (1) selon l'une des revendications précédentes, **caractérisé en ce que** la passivation du composant (2) est réalisée par surmoulage du composant (2) au moyen d'une matière à mouler par injection (13), le substrat (4) étant entouré sensiblement entièrement par le boîtier (3) uniquement dans la première zone de substrat (8).
